# EUROPEAN PATENT APPLICATION

(11) **EP 1 734 513 A1**
(43) Date of publication of application: **20.12.2006**
(21) Application number: 06251479.9
(22) Date of filing: 20.03.2006
(51) Int. Cl.: G11B 5/64, G11B 5/851, C23C 14/34

(54) **Enhanced oxide-containing sputter target alloy compositions**

(30) Priority: 15.06.2005 US 152104
(71) Applicant: Heraeus, Inc., Chandler AZ 85226 (US)
(72) Inventor: Racine, Michael Gene, Phoenix, AZ 85044 (US); Das, Anirban, Tempe, AZ 85283 (US); Kennedy, Steven Roger, Chandler, AZ 85226 (US); Chung, Kyung, Phoenix, AZ 85045 (US)
(74) Representative: Hill, Justin John

(57) **Abstract**

A sputter target, where the sputter target is comprised of cobalt (Co), platinum (Pt), a single-component oxide or a multi-component oxide, and an elemental metal additive. The elemental metal additive has a reduction potential of greater than -0.03 electron volts, and is substantially insoluble with cobalt (Co) at room temperature. The elemental metal additive is copper (Cu), silver (Ag), or gold (Au), and the sputter target is further comprised of chromium (Cr) and/or boron (B). The sputter target is comprised of between 2 atomic % and 10 atomic % copper (Cu), silver (Ag), or gold (Au) or other elemental metal additive. Accordingly, the enhanced sputter target provides significant improvements in thermal stability and SNR, through enhancements to magnetocrystalline anisotropy and increased grain-to-grain segregation.

## Description

### FIELD OF THE INVENTION

The present invention relates to sputter targets and, more particularly, relates to magnetic data-storing thin films sputtered from sputter targets which are comprised of alloy compositions with improved metallurgical characteristics.

### DESCRIPTION OF THE RELATED ART

The process of direct current ("DC") magnetron sputtering is widely used in a variety of fields to provide thin film material deposition of a precisely controlled thickness and within narrow atomic fraction tolerances on a substrate, for example to coat semiconductors and/or to form films on surfaces of magnetic recording media. In one common configuration, a racetrack-shaped magnetic field is applied to the sputter target by placing magnets on the backside surface of the target. Electrons are trapped near the sputtering target, improving argon ion production and increasing the sputtering rate. Ions within this plasma collide with a surface of the sputter target causing the sputter target to emit atoms from the sputter target surface. The voltage difference between the cathodic sputter target and an anodic substrate that is to be coated causes the emitted atoms to form the desired film on the surface of the substrate.

In the reactive sputtering process, the vacuum chamber partially filled with a chemically reactive gas atmosphere, and material which is sputtered off of the target chemically reacts with the reactive species in the gas mixture to form a chemical compound which forms the film.

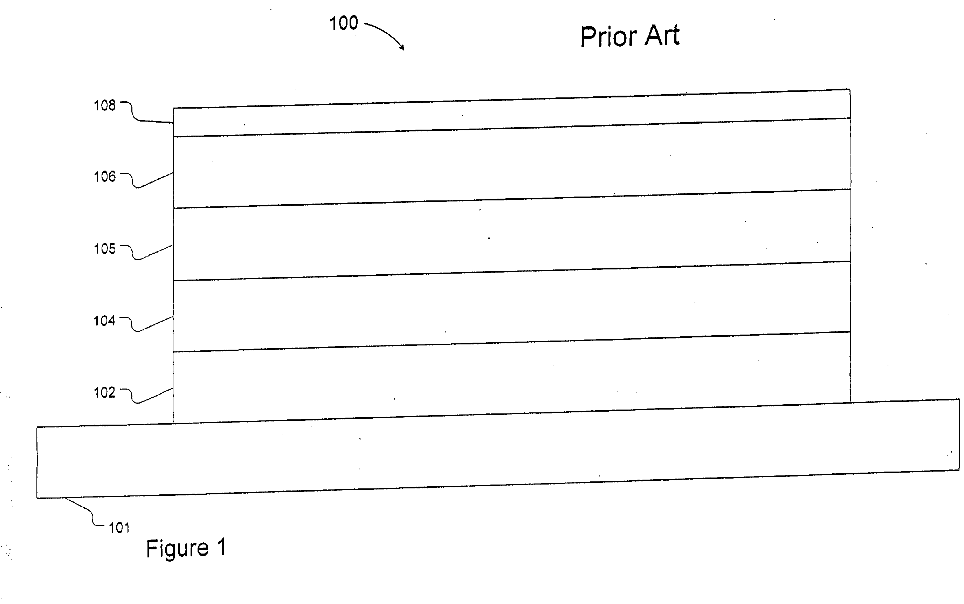

During the production of conventional magnetic recording media, layers of thin films are sequentially sputtered onto a substrate by multiple sputter targets, where each sputter target is comprised of a different material, resulting in the deposition of a thin film "stack." Figure 1 illustrates a typical thin film stack for conventional magnetic recording media. At the base of the stack is non-magnetic substrate 101, which is typically aluminum or glass. Seed layer 102, the first deposited layer, forces the shape and orientation of the grain structure of higher layers, and is commonly comprised of NiP or NiA1. Next, non-magnetic underlayer 104, which often includes one to three discrete layers, is deposited, where the underlayer is typically a chromium-based alloy, such as CrMo, or CrTi. Interlayer 105, which includes one or two separate layers, is formed above underlayer 104, where interlayer 105 is cobalt-based and lightly magnetic. Magnetic data-storing layer 106, which may include two or three separate layers, is deposited on top of interlayer 105, and carbon lubricant layer 108 is formed over magnetic layer 106.

The amount of data that can be stored per unit area on a magnetic recording medium is directly related to the metallurgical characteristics and the composition of the data-storing layer and, correspondingly, to the sputter target material from which the data-storing layer is sputtered. To sustain this continuous growth in data storage capacity, a technique known as "perpendicular magnetic recording" ("PMR"), as opposed to conventional "longitudinal magnetic recording" ("LMR"), has been the most promising and efficient technology for the magnetic data storage industry, due to its higher write efficiency using a perpendicular single-pole recording head, in combination with a soft underlayer. Using PMR, bits are recorded perpendicular to the plane of the magnetic recording medium, allowing for a smaller bit size and greater coercivity. In the future, PMR is expected to increase disk coercivity and strengthen disk signal amplitude, translating into superior archival data retention.

In order to achieve a high recording density in PMR media, thermal stability should be high, and media noise performance should be low. One approach to realizing the essential thermal stability and media noise requirements in PMR media is to provide a granular magnetic media with magnetic domains having high magnetocrystalline anisotropy, and to adequately encapsulate a fine grain microstructure in a structurally, magnetically and electrically insulating matrix. To achieve this goal, elements with a relatively high atomic radii and sufficient solid solubility in cobalt (Co) have been added to increase coercivity.

In addition to the anisotropic energy enhancements realized by conventional LMR, PMR requires a much finer grain microstructure with adequate grain-to grain segregation and negligible cross-talk between the magnetic domains. The inclusion of an oxygen-rich grain boundary region containing stoichiometric oxides, which are precipitated in the grain boundary due to negligible solid solubility in the magnetic phase, has significantly improved grain refinement and has provided excellent microstructural, magnetic and electrical isolation. These and other conventional techniques have shown significant improvements in the realization of well-isolated grain structures and large magnetic anisotropy energy (Kᵤ) values in oxygen-containing magnetic recording media, such as magnetic recording media comprised of CoPtCrO, CoPtCr-SiO₂, or CoPtTa₂O₅.

As grain refinement in granular magnetic media approaches the limits of magnetic dipole stability, a sufficient grain-to-grain separation must be established such that each grain is not influenced by its contiguous neighbors, and the magnetocrystalline anisotropy must be increased. While the introduction of oxygen in the grain boundary has been observed to render a better signal-to-noise ratio ("SNR") performance by further encapsulating the magnetic grains, the conventional approach to achieving these desired properties is to use single component oxide, such as SiO₂, Y₂O₃, Al₂O₃, TiO₂, Ta₂O₅, Nb₂O₅, for media applications. Recent studies have proven the beneficial effects of incorporating oxygen through reactive sputtering and/or single oxide-containing sputter targets, in CoPt, CoPtCr, CoPtB, and/or CoPtCrB-containing granular magnetic media. This approach has provided significant improvement in the realization of well-isolated grain structures, however these oxides do not realize the best granular media performance with regard to SNR and thermal stability within PMR media. Moreover, techniques such as those described in U.S. Patent Application No. 11/110,105, entitled "Enhanced Multi-Component Oxide-Containing Sputter Target Alloy Compositions," filed April 19, 2005, provide additional enhancement of grain-to-grain microstructural, magnetic, and electrical isolation through the modulation of oxide properties in multi-component oxide containing granular media.

It is therefore considered highly desirable to provide a magnetic recording medium with a dense grain structure at the magnetic data-storing layer, to improve the SNR and increase potential data storage capabilities. In particular, it is desirable to provide single-component or multi-component oxide-containing alloy compositions which can be used in sputter targets and sputtered into thin films.

### SUMMARY OF THE INVENTION

The present invention relates to sputter targets and, more particularly, relates to magnetic data-storing thin films sputtered from sputter targets which are comprised of alloy compositions with improved metallurgical characteristics.

According to a first arrangement, the present invention is a sputter target, where the sputter target is comprised of cobalt (Co), platinum (Pt), a single-component oxide, and an elemental metal additive. The elemental metal additive has a reduction potential of greater than -0.03 electron volts, and is substantially insoluble with cobalt (Co) at room temperature.

Accordingly, significant improvements in thermal stability and SNR, through enhancements to magnetocrystalline anisotropy and increased grain-to-grain segregation, are possible using a single-component or multi-component oxide containing composition with an elemental metal additive which is insoluble in the cobalt (Co)-containing magnetic phase and is resistive towards oxidation. As such, the present invention contemplates enhanced sputter target alloy compositions using metal additives which render better magnetics for PMR media manufactured using magnetron sputtering.

The sputter target is further comprised of chromium (Cr) and/or boron (B). The sputter target is comprised of between 2 atomic % and 10 atomic % elemental metal additive, where the elemental additive is copper (Cu), silver (Ag), or gold (Au).

PMR media have more stringent requirements regarding thermal stability and SNR performance over LMR media, therefore calling for the introduction of new additives for conventional recording media in order to render higher magnetocrystalline anisotropy, a fine grain structure and improved grain-to-grain microstructural-magnetic-electrical isolation. The addition of elemental metals, such as copper (Cu), silver (Ag) and gold (Au) in the appropriate amounts in CoPt-based systems, shows significant improvements in the increase of magnetocrystalline anisotropy and coercivity (H_{c}), and the realization of a fine grain microstructure in LMR media.

According to a second arrangement, the present invention is a sputter target. The sputter target is comprised of cobalt (Co), platinum (Pt), a multi-component oxide, and an elemental metal additive, where the elemental metal additive has a reduction potential of greater than -0.03 electron volts, and is substantially insoluble with cobalt (Co) at room temperature.

The present invention provides for enhanced alloy compositions which can be used to sputter granular magnetic media containing CoPt-based compositions which render better thermal stability and SNR, compared to conventional compositions. Oxide-containing CoPt-based media show a significant improvement in grain size refinement and segregation. These benefits are further enhanced when coupled with an increase in magnetocrystalline anisotropy energy, when additive metals are added to the magnetic alloy composition.

According to a third arrangement, the present invention is a magnetic recording medium, including a substrate, and a data-storing thin film layer formed over the substrate. The data-storing thin film layer sputter target is comprised of cobalt (Co), platinum (Pt), a single-component oxide, and an elemental metal additive, where the elemental metal additive has a reduction potential of greater than -0.03 electron volts, and is substantially insoluble with cobalt (Co) at room temperature.

According to a fourth arrangement, the present invention is a magnetic recording medium, including a substrate, and a data-storing thin film layer formed over the substrate. The data-storing thin film layer sputter target is comprised of cobalt (Co), platinum (Pt), a multi-component oxide, and an elemental metal additive. The elemental metal additive has a reduction potential of greater than -0.03 electron volts, and is substantially insoluble with cobalt (Co) at room temperature.

The present invention is used to fabricate new granular magnetic media with enhanced sputter target alloy compositions which provide better thermal stability and SNR. Specifically, the present invention provides for enhancements to magnetocrystalline anisotropy, grain refinement and segregation in granular magnetic media, through incorporation of elemental metals such as copper (Cu), silver (Ag), and gold (Au), in conjunction with an oxide containing grain boundary region in CoPt based system. Additionally, the present invention benefits conventional commercial LMR media, by enhancing the oxide-containing grain boundary region with metals which provide for grain refinement and isolation, augmenting magnetic performance.

According to a fifth arrangement, the present invention is a method for manufacturing a magnetic recording medium. The method includes the step of sputtering at least a first data-storing thin film layer over a substrate from a sputter target, where the data-storing thin film layer sputter target is comprised of cobalt (Co), platinum (Pt), a single-component oxide, and an elemental metal additive. The elemental metal additive has a reduction potential of greater than -0.03 electron volts, and is substantially insoluble with cobalt (Co) at room temperature.

According to a sixth arrangement, the present invention is a method for manufacturing a magnetic recording medium, including the step of sputtering at least a first data-storing thin film layer over a substrate from a sputter target. The data-storing thin film layer sputter target is comprised of cobalt (Co), platinum (Pt), a multi-component oxide, and an elemental metal additive, where the elemental metal additive has a reduction potential of greater than -0.03 electron volts, and is substantially insoluble with cobalt (Co) at room temperature.

In the following description of the preferred embodiment, reference is made to the accompanying drawings that form a part thereof, and in which is shown by way of illustration a specific embodiment in which the invention may be practiced. It is to be understood that other embodiments may be utilized and changes may be made without departing from the scope of the present invention.

### BRIEF DESCRIPTION OF THE DRAWINGS

Referring now to the drawings in which like reference numbers represent corresponding parts throughout:

Figure 1 depicts a typical thin film stack for conventional magnetic recording media;

Figure 2 depicts a thin film stack in which the magnetic data-storing layer has been sputtered by a sputter target comprised of the enhanced oxide-containing sputter target alloy composition according to one embodiment of the present invention;

Figure 3 depicts an equilibrium binary phase diagram for a cobalt-copper (Co-Cu) based system;

Figure 4 depicts an equilibrium binary phase diagram for a cobalt-silver (Co-Ag) based system;

Figure 5 depicts an equilibrium binary phase diagram for a cobalt-gold (Co-Au) based system; and

Figure 6 is a flow chart depicting a method for manufacturing a magnetic recording medium, according to a second embodiment of the present invention.

### DETAILED DESCRIPTION OF THE INVENTION

The present invention provides a magnetic recording medium with a dense grain structure at the magnetic data-storing layer, which improves the SNR and increases potential data storage capabilities. Furthermore, the present invention provides improved oxide-containing alloys which can be used in sputter targets and sputtered into thin films.

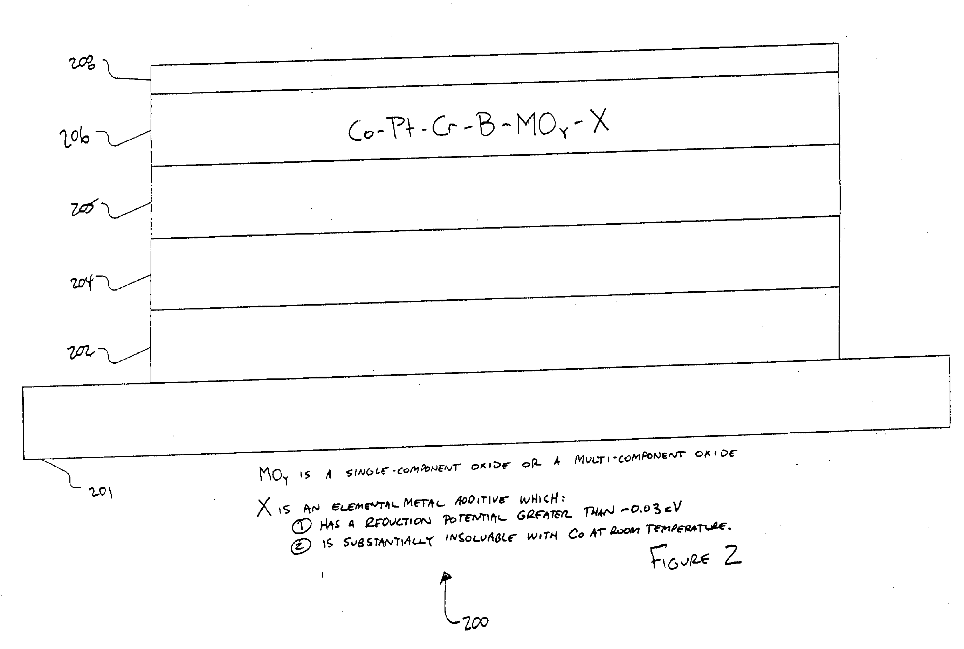

Figure 2 depicts a thin film stack in which the magnetic data-storing layer has been sputtered by a sputter target comprised of the enhanced oxide-containing sputter target alloy composition according to one embodiment of the present invention. Briefly, the magnetic recording medium includes a substrate, and a data-storing thin film layer formed over the substrate. The data-storing thin film layer sputter target is comprised of cobalt (Co), platinum (Pt), a single-component oxide or a multi-component oxide, and an elemental metal additive. The elemental metal additive has a reduction potential of greater than -0.03 electron volts, and is substantially insoluble with cobalt (Co) at room temperature.

In more detail, magnetic recording medium 200 includes substrate 201, and data-storing thin film layer 206 formed over substrate 201. Data-storing thin film layer 206 is comprised of cobalt (Co), platinum (Pt), a single-component oxide, and an elemental metal additive, where the elemental metal additive has a reduction potential of greater than -0.03 electron volts, and is substantially insoluble with cobalt (Co) at room temperature.

Alternatively, data-storing thin film layer 206 is comprised of cobalt (Co), platinum (Pt), a multi-component oxide, and an elemental metal additive, where the elemental metal additive has a reduction potential of greater than -0.03 electron volts, and is substantially insoluble with cobalt (Co) at room temperature.

In either case, Figure 2 depicts data-storing thin film layer 206 as being comprised of Co-Pt-Cr-B-*MO_{y}*-*X*, where *MO_{y}* represents a single-component oxide or a multi-component oxide, and where *X* represents an elemental metal additive, where the elemental metal additive has a reduction potential of greater than -0.03 electron volts, and is substantially insoluble with cobalt (Co) at room temperature.

As indicated above, magnetic recording media 200 can include other thin film layers, including seed layer 202, non-magnetic underlayer 204, interlayer 205, and carbon lubricant layer 208, although in alternate aspects of the present invention some or all of these layers are omitted. Elements which have limited solid solubility in the primary magnetic cobalt (Co) phase and which precipitate in the grain boundary region separating the magnetic grains demonstrate significant improvements in the SNR.

The granular magnetic media according to the present invention is composed of enhanced sputter target alloy compositions which provide better thermal stability and SNR. Specifically, the magnetic recording media includes enhancements to magnetocrystalline anisotropy, grain refinement and segregation in granular magnetic media, through incorporation of elemental metals, in conjunction with an oxide containing grain boundary region in CoPt based system. Conventional commercial LMR media is also benefited, by enhancing the oxide-containing grain boundary region with metals which provide for grain refinement and isolation, increasing magnetic performance.

With regard to thermal stability and SNR performance, PMR media has more stringent requirements than LMR media, and calls for introduction of new additives for conventional CoPt containing media, in order to render higher magnetocrystalline anisotropy, improve fine grain structure, and increase and grain-to-grain microstructural-magnetic-electrical isolation. The addition of the above-mentioned elemental metals in CoPt-based systems has shown significant improvements in increasing the magnetocrystalline anisotropy and coercivity (H_{c}), and has realized an improved fine grain microstructure in PMR and LMR media.

Data-storing thin film layer 206 is particularly well suited for PMR applications. The choice of elements used in the metal oxide is based upon several criteria, where the use of different oxides with compensating and reinforcing properties realizes the best granular media performance with regard to SNR and thermal stability in the perpendicular magnetic media.

In more detail, in order for PMR to achieve high recording density, the data-storing thin film layer must be comprised of a material with high thermal stability and low media noise performance. Granular magnetic media containing CoCrPt or CoPt-based alloys, with magnetic domains encapsulated in an insulating matrix, are not only highly resistive to thermal agitation due to their large magnetocrystalline anisotropy, but they also provide an enhanced performance regarding SNR, due to the grain size reduction. As grain refinement in the granular magnetic media approaches the limits of magnetic dipole stability, however, it becomes increasingly important to develop materials with sufficient grain-to-grain separation such that each grain is not magnetically influenced by its contiguous neighbors in the bulk.

For PMR, where the requirements for grain refinement and separation are much more stringent than LMR, an oxygen-containing grain boundary in granular media has been observed to render better magnetic properties, making the incorporation of oxygen through reactive sputtering and/or-single oxide (such SiO₂, Al₂O₃, Ta₂O₅, or Nb₂O₅)-containing targets beneficial. The present invention further enhances the benefits of oxygen-rich grain boundary regions in magnetic media through the use of sputter targets containing single or multiple-component oxides. This objective is achieved through the modulation of different oxide properties related to oxidation propensity, glass formation tendency, and magnetic-dielectric behaviors in a multi-component oxide matrix incorporated in the magnetic media, using sputter targets containing multi-component oxides selected on the basis of specific criteria

Of the different metals which have limited solid-solubility with cobalt (Co) at room temperature, copper (Cu), silver (Ag) and gold (Au) include a relatively high oxidation resistance. The standard reduction potentials for each are shown below, in Table 1:

**Table 1.**

| | Standard Reduction Potential |
|---|---|
| Cu⁺ | 0.52 |
| Cu⁺² | 0.34 |
| Ag⁺ | 0.799 |
| Au⁺ | 1.83 |
| Au⁺³ | 1.52 |

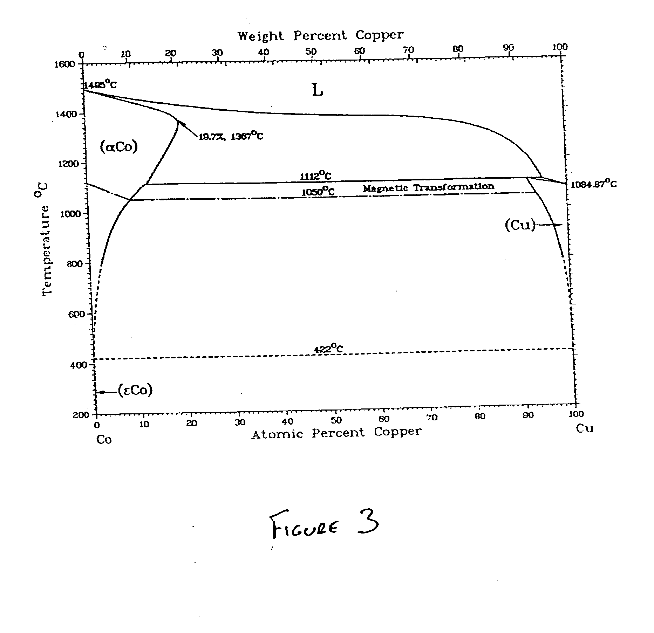

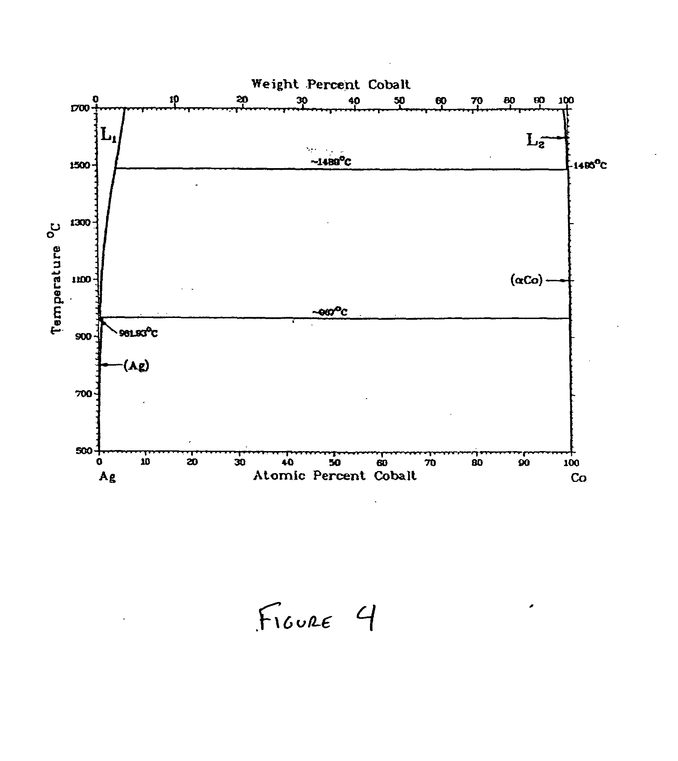

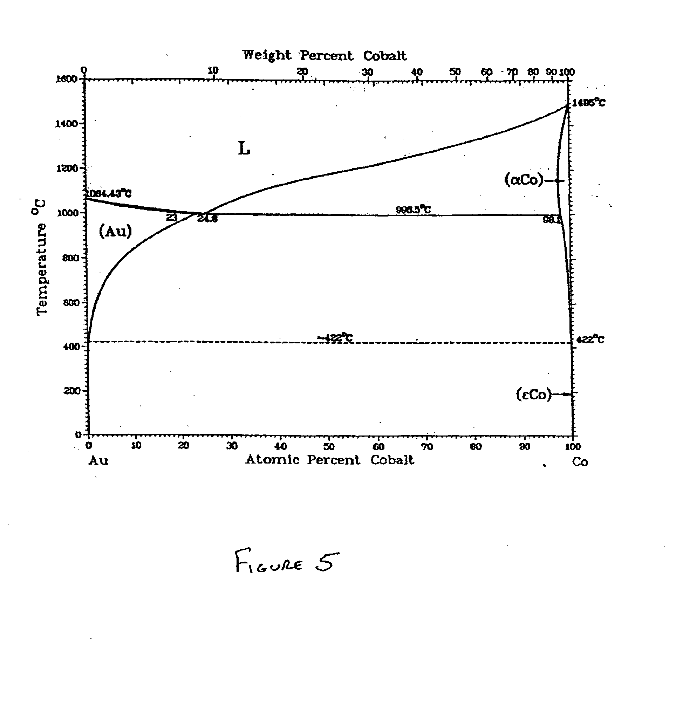

Figure 3 depicts an equilibrium binary phase diagram for a Co-Cu based system, Figure 4 depicts an equilibrium binary phase diagram for a Co-Ag-based system, and Figure 5 depicts an equilibrium binary phase diagram for a Co-Au-based system. At room temperature, which is taken to be roughly 21 °C to 23°C (68°F to 72°F, or 295 K to 296 K), each of copper (Cu), silver (Ag) and gold (Au) are substantially insoluble with cobalt (Co). As depicted in the respective figures, substantial insolubility,' is a state where the solubility of the elemental metal additive is reasonably close to zero.

Although the elemental metal additive is preferably copper (Cu), silver (Ag), or gold (Au), other elemental metal additives can also be used. The sputter target is further comprised of chromium (Cr) and/or boron (B). The addition of these elements makes it possible to further enhance the grain-to-grain microstructural, magnetic and electrical isolation of the oxide-containing granular media. In an alternate aspect, chromium (Cr) and/or boron (B) are omitted. The sputter target is comprised of between 2 atomic % and 10 atomic % elemental metal additive, where the elemental metal additive can be copper (Cu), silver (Ag), or gold (Au) or other additives, although sputter targets containing less or more metal additive are also contemplated by the present invention. The atomic % of cobalt (Co), platinum (Pt), chromium (Cr), boron (B), single-component oxide or multi-component oxide within the composition can vary, and is not limited to any particular atomic %.

According to an alternate arrangement, the present invention is a sputter target, where the sputter target is comprised of cobalt (Co), platinum (Pt), a single-component oxide, and an elemental metal additive. The elemental metal additive has a reduction potential of greater than -0.03 electron volts, and is substantially insoluble with cobalt (Co) at room temperature. Alternately, the present invention is a sputter target, where the sputter target is comprised of cobalt (Co), platinum (Pt), a multi-component oxide, and an elemental metal additive. The elemental metal additive has a reduction potential of greater than -0.03 electron volts, and is substantially insoluble with cobalt (Co) at room temperature.

Significant improvements in thermal stability and SNR, through enhancements to magnetocrystalline anisotropy and increased grain-to-grain segregation, are possible using a sputter target composed of the aforementioned single-component or multi-component oxide containing composition with an elemental metal additive, which is insoluble in the Co-containing magnetic phase and is resistive towards oxidation. The present invention contemplates these enhanced sputter target alloy compositions which use metal additives which render better magnetics for PMR media manufactured using magnetron sputtering.

The present invention can be used to process magnetic films using sputter targets containing single-component or multi-component oxides, particularly in PMR applications, where the requirements grain structure refinement and isolation are more stringent in order to minimize degradation in SNR and realize a larger magnetic anisotropy energy (Kᵤ). Commercial horizontal recording media can also benefit from the essential attributes of a multi-component oxide matrix for grain refinement and isolation to enhance the magnetic performance. Moreover, elemental metals which are insoluble in a primary magnetic Co phase, when added to CoPt-based systems have shown the ability to significantly improve the magnetocrystalline anisotropy, coercivity (H_{c}) and grain size refinement in LMR media.

The present invention provides for enhanced alloy compositions which can be used to sputter granular magnetic media containing CoPt-based compositions which render better thermal stability and SNR, compared to conventional compositions. Oxide-containing CoPt-based media show a significant improvement in grain size refinement and segregation. These benefits are further enhanced when coupled with an increase in magnetocrystalline anisotropy energy, when additive metals are added to the magnetic alloy composition.

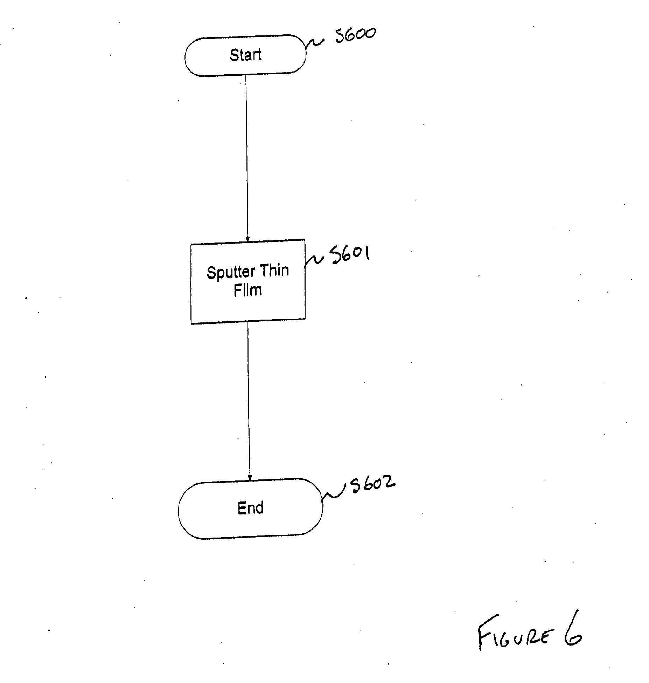

Figure 6 is a flow chart depicting a method for manufacturing a magnetic recording medium, according to an additional embodiment of the present invention. Briefly, the method includes the step of sputtering at least a first data-storing thin film layer over a substrate from a sputter target, where the data-storing thin film layer sputter target is comprised of cobalt (Co), platinum (Pt), a single-component oxide, and an elemental metal additive. The elemental metal additive has a reduction potential of greater than -0.03 electron volts, and is substantially insoluble with cobalt (Co) at room temperature. Alternatively, the method includes the step of sputtering at least a first data-storing thin film layer over a substrate from a sputter target. The data-storing thin film layer sputter target is comprised of cobalt (Co), platinum (Pt), a multi-component oxide, and an elemental metal additive, where the elemental metal additive has a reduction potential of greater than -0.03 electron volts, and is substantially insoluble with cobalt (Co) at room temperature.

The present invention is used to fabricate new granular magnetic media with enhanced sputter target alloy compositions which provide better thermal stability and SNR. Specifically, the present invention provides for enhancements to magnetocrystalline anisotropy, grain refinement and segregation in granular magnetic media, through incorporation of elemental metals such as copper (Cu), silver (Ag), and gold (Au), in conjunction with an oxide-containing grain boundary region in CoPt based system.

In more detail, the process begins (step S300), at least a first data-storing thin film layer is sputtered over a substrate from a sputter target (step S301), and the process ends (step S302). The data-storing thin film layer sputter target is comprised of cobalt (Co), platinum (Pt), a multi-component oxide or a single-component oxide, and an elemental metal additive, where the elemental metal additive has a reduction potential of greater than -0.03 electron volts, and is substantially insoluble with cobalt (Co) at room temperature.

Accordingly, significant improvements in thermal stability and SNR, through enhancements to magnetocrystalline anisotropy and increased grain-to-grain segregation, are possible using a single-component or multi-component oxide containing composition with an elemental metal additive, which is insoluble in the cobalt (Co)-containing magnetic phase and is resistive towards oxidation. As such, the present invention contemplates enhanced sputter target alloy compositions using metal additives which render better magnetics for PMR media manufactured using magnetron sputtering.

To realize higher magnetocrystalline anisotropy and a higher coercivity (H_{c}), the metal additive is elemental form and is not bonded to oxygen (O), in order to achieve a lower propensity towards oxidation during sputtering and while in the sputter target form. Additionally, the elemental metal additive has an oxidation propensity so that it does not form a sub-stoichiometric oxide and render the oxide grain boundary region also sub-stoichiometric. Oxygen non-stoichiometry in the magnetic media as well as the target results in electrical conduction, where electron or hole conduction compensates for cation/anion vacancies which are also a function of the oxygen partial pressure during media processing, between magnetic grains which upon interacting with the applied magnetic field during magnetron sputtering would adversely affect the magnetic performance of the media as well as the sputter performance of the targets.

Thus the present invention claims, enhanced alloy compositions leading to granular magnetic media containing CoPt(Cr)(B)-*MO_{Y}*-*X*, where *MO_{Y}* is a single-component or multi-component metal oxide and X is copper (Cu), silver (Ag), or gold (Au), manufactured using magnetron sputtering, renders better thermal stability and SNR performance as compared to conventional compositions.

The use of a single-component or multi-component oxide-containing alloy composition enhances the grain-to-grain microstructural magnetic and electrical isolation, through the modulation of oxide properties of the different constituting oxides in the magnetic media. Specific metal oxides can be used for this purpose which can be used in conjunction with known oxides, such as SiO₂/Al₂O₃ and others, to form a single-component or multi-component insulating oxide matrix encapsulating the magnetic grains.

Oxides which rarely form a solid solution with metals have the inherent tendency to precipitate in the grain boundary regions in CoCrPt or CoPt-based granular media and thereby enhance microstructural segregation of the magnetic grains. These oxides do not interfere with the epitaxial growth of the oxygen containing CoCrPt or CoPt-based thin film media and therefore lead to the suppression of degradation in magnetic anisotropy energy (Kᵤ).

Oxygen introduced through reactive sputtering in thin film magnetic media to enrich oxygen content in the grain boundaries, and use of single oxides in conjunction with CoCrPt and CoPt deliver better magnetic behavior in PMR media, due to the above-identified effects of the oxygen containing media. Oxygen-containing granular magnetic media manufactured using oxide-containing targets, however, have demonstrated superior magnetic performance than media containing oxygen incorporated through reactive sputtering.

The invention has been described with particular illustrative embodiments. It is to be understood that the invention is not limited to the above-described embodiments and that various changes and modifications may be made by those of ordinary skill in the art without departing from the spirit and scope of the invention.

## Claims

1. A sputter target, wherein the sputter target is comprised of cobalt (Co), platinum (Pt), a single-component oxide, and an elemental metal additive,
wherein the elemental metal additive has a reduction potential of greater than -0.03 electron volts, and is substantially insoluble with cobalt (Co) at room temperature.

2. The sputter target according to Claim 1, wherein the elemental metal additive is copper (Cu), silver (Ag), or gold (Au).

3. The sputter target according to Claim 1, wherein the sputter target is further comprised of chromium (Cr).

4. The sputter target according to Claim 1, wherein the sputter target is further comprised of boron (B).

5. The sputter target according to Claim 1, wherein the sputter target is comprised of between 2 atomic % and 10 atomic % elemental metal additive.

6. A magnetic recording medium comprising:
a substrate; and
a data-storing thin film layer formed over said substrate,
wherein said data-storing thin film layer sputter target is comprised of cobalt (Co), platinum (Pt), a single-component oxide, and an elemental metal additive,
wherein the elemental metal additive has a reduction potential of greater than -0.03 electron volts, and is substantially insoluble with cobalt (Co) at room temperature.

7. The magnetic recording medium according to Claim 6, wherein the elemental metal additive is copper (Cu), silver (Ag), or gold (Au).

8. The magnetic recording medium according to Claim 6, wherein said data-storing thin film layer is further comprised of chromium (Cr).

9. The magnetic recording medium according to Claim 6, wherein said data-storing thin film layer is further comprised of boron (B).

10. The sputter target according to Claim 6, wherein the sputter target is comprised of between 2 atomic % and 10 atomic % elemental metal additive.

11. A method for manufacturing a magnetic recording medium, comprising the step of sputtering at least a first data-storing thin film layer over a substrate from a sputter target, wherein said data-storing thin film layer sputter target is comprised of cobalt (Co), platinum (Pt), a single-component oxide, and an elemental metal additive, wherein the elemental metal additive has a reduction potential of greater than -0.03 electron volts, and is substantially insoluble with cobalt (Co) at room temperature.

12. A sputter target, wherein the sputter target is comprised of cobalt (Co), platinum (Pt), a multi-component oxide, and an elemental metal additive,
wherein the elemental metal additive has a reduction potential of greater than -0.03 electron volts, and is substantially insoluble with cobalt (Co) at room temperature.

13. The sputter target according to Claim 12, wherein the elemental metal additive is copper (Cu), silver (Ag), or gold (Au).

14. The sputter target according to Claim 12, wherein the sputter target is further comprised of chromium (Cr).

15. The sputter target according to Claim 12, wherein the sputter target is further comprised of boron (B).

16. The sputter target according to Claim 12, wherein the sputter target is comprised of between 2 atomic % and 10 atomic % elemental metal additive.

17. A magnetic recording medium comprising:
a substrate; and
a data-storing thin film layer formed over said substrate,
wherein said data-storing thin film layer sputter target is comprised of cobalt (Co), platinum (Pt), a multi-component oxide, and an elemental metal additive,
wherein the elemental metal additive has a reduction potential of greater than -0.03 electron volts, and is substantially insoluble with cobalt (Co) at room temperature.

18. The magnetic recording medium according to Claim 17, wherein the elemental metal additive is copper (Cu), silver (Ag), or gold (Au).

19. The magnetic recording medium according to Claim 17, wherein said data-storing thin film layer is further comprised of chromium (Cr).

20. The magnetic recording medium according to Claim 17, wherein said data-storing thin film layer is further comprised of boron (B).

21. The sputter target according to Claim 17, wherein the sputter target is - comprised of between 2 atomic % and 10 atomic % elemental metal additive.

22. A method for manufacturing a magnetic recording medium, comprising the step of sputtering at least a first data-storing thin film layer over a substrate from a sputter target, wherein said data-storing thin film layer sputter target is comprised of cobalt (Co), platinum (Pt), a multi-component oxide, and an elemental metal additive, wherein the elemental metal additive has a reduction potential of greater than -0.03 electron volts, and is substantially insoluble with cobalt (Co) at room temperature.
